# Europäisches Patentamt

## European Patent Office

## Office européen des brevets

(19)

(11) Veröffentlichungsnummer: **0 015 302**
**A1**

(12) ## EUROPÄISCHE PATENTANMELDUNG

(21) Anmeldenummer: 79103125.5

(22) Anmeldetag: 24.08.79

(51) Int. Cl.³: **H 05 K 5/00, H 04 N 5/64**

(30) Priorität: 16.02.79 DE 2905929

(43) Veröffentlichungstag der Anmeldung: 17.09.80
Patentblatt 80/19

(84) Benannte Vertragsstaaten: **AT BE CH DE FR GB IT LU NL SE**

(71) Anmelder: **GRUNDIG E.M.V. Elektro-Mechanische Versuchsanstalt Max Grundig, Kurgartenstrasse 37, D-8510 Fürth (DE)**

(72) Erfinder: **Schade, Kurt, Dipl.-Ing., Waldmeisterstrasse 6, D-8510 Fürth/Bayern (DE)**

(54) **Fernsehgerätechassis.**

(57) Das Chassis eines Fernsehgerätes ist aus einzelnen steckbaren Bausteinen aufgebaut, in denen eine Anzahl von meist kleineren Bauelementen und Bauteilen zusammen mit einer gedruckten Schaltungsplatte in einer meist für sich funktionsfähigen Einheit zusammengeschlossen sind. Jeder solcher Baustein ist mit einem Gehäuse (5) versehen, das die bestückte Schaltungsplatte vor äußerem Zugriff schützt und das daneben noch Abschirm-, Wärme-ableitungs- und Diagnosefunktionen haben kann. Das Gehäuse trägt mindestens auf einer Außenseite ein oder mehrere Verschlußelemente (11), die in Ausnehmungen der Schaltungsplatte eingreifen. Das Herausziehen der bestückten Schaltungsplatte aus dem Gehäuse ist erst nach Zerstörung der Verschlußelemente (11) möglich. Auf diese Weise ist jeder unfachmännische Eingriff in einen Baustein sofort erkennbar.

EP 0 015 302 A1

ACTORUM AG

– 1 –

## FERNSEHGERÄTECHASSIS

Beschreibung

Stand der Technik

Die derzeitige Technik bevorzugt den Aufbau von Fernsehgerätechassis aus einzelnen steckbaren abgeschlossenen Funktionsgruppen, in denen eine Anzahl von meist kleineren Bauelementen
und Bauteilen zusammen mit einer gedruckten Schaltungsplatte
in einer meist für sich funktionsfähigen Einheit zusammengeschlossen sind. Durch diese sogenannte Modultechnik ergibt
sich ein ganz einfacher Service; es braucht nur noch der defekte Teil – einer der Module – ausgewechselt, also seine
Halterung gelöst und der Modul aus der Steckverbindung mit der
gedruckten Verbindungsplatte im Chassis gezogen zu werden.
Solche Fernsehempfänger brauchen daher nicht mehr in die Werkstatt zur Reparatur transportiert zu werden; die Reparaturkosten können deshalb niedriger festgelegt werden, und außerdem braucht die ganze Reparatur nur wenige Minuten zu dauern.

Folgende Schaltstufen sind derzeit in Modul-Bauart ausgeführt: Bild-ZF-Verstärker, Ton-ZF-Verstärker, Ton-NF-Verstärker, Video-Verstärker, der gesamte Farbteil, Farbdifferenz-Endstufe, Vertikal-Ablenkteil und Horizontal-Ablenkteil. Besondere Bauteile, insbesondere in Form von Kennzapfen oder Kennstiften, verhindern ein versehentliches Vertauschen der Bausteine untereinander, so daß von vornherein elektrische Defekte durch Einstecken falscher Module vermieden werden. Schraubverbindungen und Haltebügel verhindern ein ungewolltes Lösen der Elemente von der Grunddruckplatte.

Eine derartige Technik bietet auch besondere Möglichkeiten der Automatisierung und Rationalisierung in der Fertigung, sie bringt aber insbesondere dem Handel und besonders dem Service-Techniker mehrere Vorteile. Es wurde jedoch festgestellt, daß auch ungeschulte Kräfte, die ohne Kenntnis der neuen Technik sind oder keine Service-Kenntnisse haben, an den Modulen arbeiten, wenn sich irgendwelche Defekte zeigen. Hierdurch entstehen dann häufig zusätzliche elektrische und mechanische Defekte im Modul, die für den geschulten Reparateur nur unter größerem Zeit- und Kostenaufwand behebbar sind. Außerdem werden solche unbefugten Eingriffe häufig bestritten, um die vom Hersteller oder Handel zugesicherte Gewährleistung nicht zu verlieren. Auf diese Weise entstehen dem Handel und dem Hersteller nicht zu unterschätzende Nachteile.

## Aufgabe

Der im Anspruch 1 angegebenen Erfindung liegt die Aufgabe zugrunde, bei einem in einzelne steckbare Funktionsgruppen aufgeteilten Fernsehgerätechassis erkennbar zu machen, wenn ungeschulte Kräfte an den Funktionsgruppen gearbeitet haben, um elektrische oder mechanische Defekte zu beheben.

## Vorteile

Mit dem Fernsehgerätechassis nach der Erfindung wird erreicht, daß die Funktionsgruppen besser vor Eingriffen durch ungeschulte Kräfte geschützt sind. Zumindest bietet die Erfindung den Vorteil, daß ein unbefugter Eingriff in die Funktionsgruppe sofort angezeigt und somit vom Handel oder Hersteller erkannt wird. Auf diese Weise führt die Erfindung für den Handel oder den Hersteller zu einer gewissen Kostenersparnis, da der Unbefugte sich nicht mehr auf seine Gewährleistungsansprüche berufen kann.

Vorteilhafte Weiterbildungen der Erfindung sind in den Unteransprüchen beschrieben. Die Ausgestaltung des Fernsehgerätechassis nach den Ansprüchen 2 bis 4 ist insbesondere dann vorteilhaft, wenn neben der einfachen Herstellung ein besonders wirksamer Schutz bei aktiver und passiver Störstrahlung erforderlich ist. Mit der Ausgestaltung nach Anspruch 5 wird ein Fernsehgerätechassis geschaffen, das besonders einfach herstellbar ist.


Darstellung der Erfindung


Die Erfindung wird im folgenden anhand schematischer Zeichnungen näher erläutert.


Fig. 1          ist eine Darstellung, die den prinzipiellen Aufbau des Fernsehgerätechassis
                verdeutlicht;


Fig. 2          zeigt eine perspektivische Darstellung
                einer Funktionsgruppe des gemäß der Er-
                findung aufgebauten Fernsehgerätechas-
                sis;


Fig. 3          ist eine perspektivische Darstellung einer anderen Funktionsgruppe;


Fig. 4 u. 5     sind Ausführungsbeispiele für Bauteile,
                die bei Funktionsgruppen des gemäß der
                Erfindung aufgebauten Fernsehgerätechas-
                sis verwendbar sind.


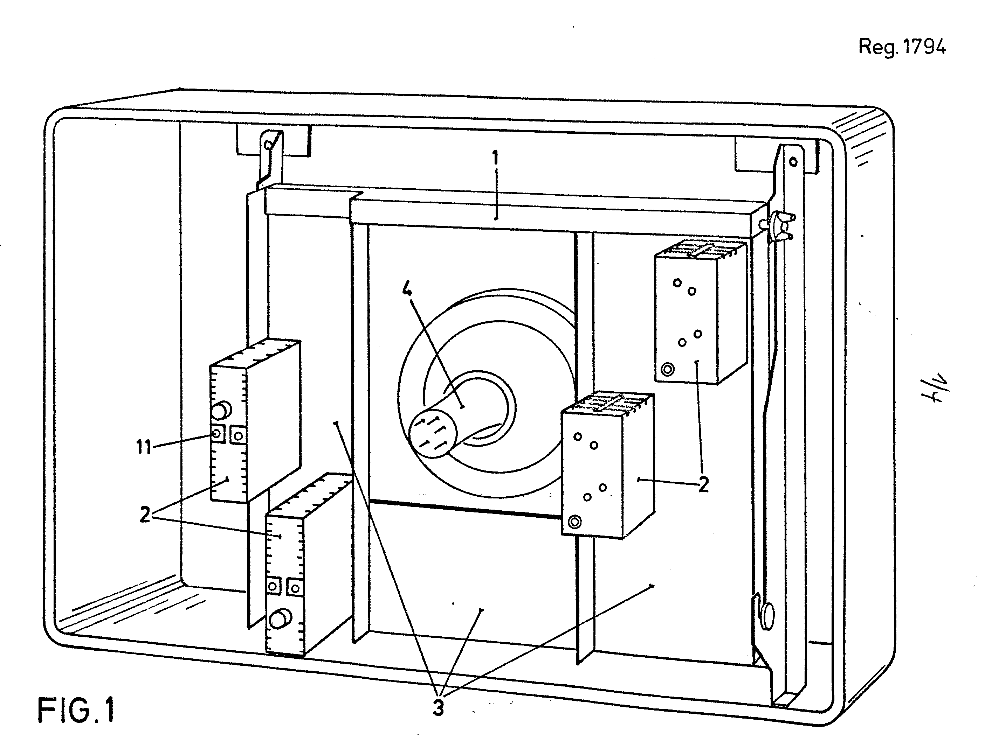

Das in Fig. 1 dargestellte Fernsehgerätechassis besteht im wesentlichen aus dem Chassisrahmen 1, den Funktionsgruppen 2 und einer allen Funktionsgruppen gemeinsamen elektrischen Leiterplatte 3. Der die Leiterplatte 3 aufnehmende Chassisrahmen 1 ist bei abgenommener Geräterückwand ausziehbar und um eine horizontale, zur Achse der Bildröhre 4 senkrechte Achse schwenbar, damit die Leiterplatte auch auf der den Funktionsgruppen 2 abgewandten Seite leicht zugänglich ist. Die einzelnen Funktionsgruppen 2 sind mit ihrem Steckverbinder in einen zugeordneten Stechverbindungsteil der Leiterplatte 3 eingesteckt und zusätzlich durch Halterungsmittel gegen ein ungewolltes Lösen von der Leiterplatte gesichert. Die Grundleiterplatte 3 und die Leiterplatten aller Funktionsgruppen 2 sind ebenso wie diese vertikal angeordnet, so daß durch die miteinander fluchtenden Platten und Funktionsgruppen mehrere Luftschächte, insbesondere mehrere gemeinsame Luftschächte, in dem Raum zwischen den Funktionsgruppen gebildet werden, um das Durchströmen von Kühlluft zu gestatten.

Die einzelnen Funktionsgruppen 2 sind je nach der in ihr enthaltenen Empfängerschaltung unterschiedlich ausgebildet. Insbesondere ist es erforderlich, bestimmte Funktionsgruppen, wie z. B. Tuner, Abstimmbaustein und ZF-Baustein, gegen passive als auch aktive Störstrahlung abzuschirmen. Diese und ähnliche Forderungen finden bei der Ausgestaltung der Funktionsgruppen des Fernsehgerätechassis gemäß der Erfindung Berücksichtigung.

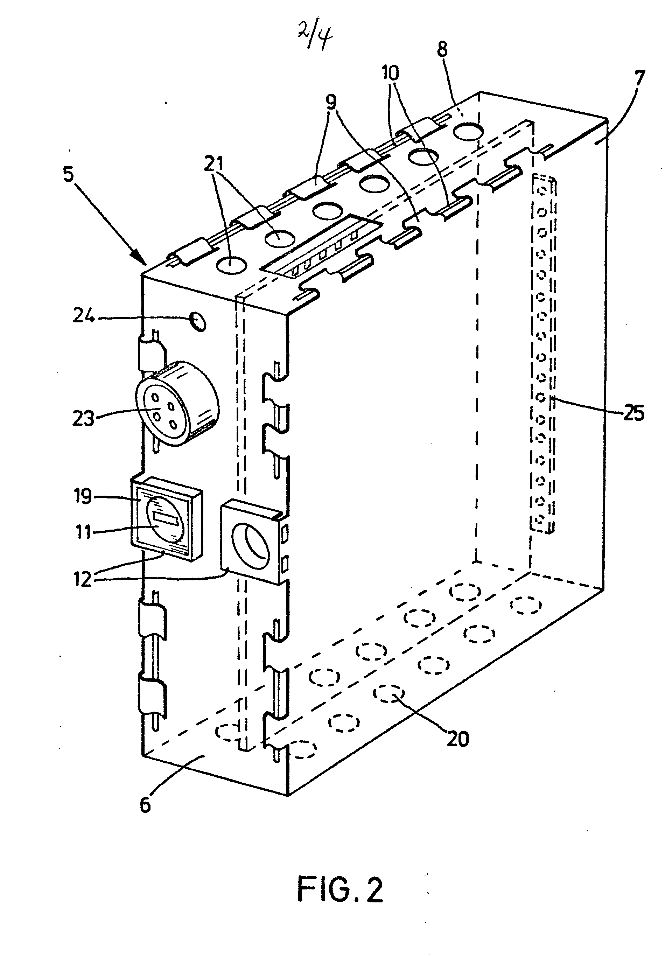

Eine einzelne Funktionsgruppe der in Fig. 2 dargestellten Art besteht aus einem im wesentlichen allseitig geschlossenen Abschirmgehäuse 5 aus dünnem Blech und einer darin befindlichen elektrischen Leiterplatte, die die Verdrahtung und die Bauelemente trägt und im Gehäuse durch Führungsprägungen und ggf. durch Lötung festgelegt ist. Das metallische Abschirmgehäuse 5, das zugleich auch für die Abführung der Verlustwärme dient, besteht aus mehreren lösbar miteinander verbundenen Teilen, und zwar aus einem rechteckigen Rahmen 6 und zwei diesem angepaßten Deckeln 7, 8. Die Verbindung zwischen Rahmen 6 und Deckel 7, 8 erfolgt dadurch, daß diese einseitig am Rahmen gelenkartig eingehängt und mindestens am anderen Ende durch eine lösbare snap-in-Verbindung verbunden sind, die dadurch gebildet ist, daß an den Längsseiten der Deckel rechtwinklig abgebogene federnde Lappen 9 hinter Prägungen 10 des Rahmens verrasten.

Es ist somit ersichtlich, daß das geschlossene Abschirmgehäuse 5 die Bauelemente und Bauteile der Funktionsgruppe vor äußerem Zugriff schützt. Da jedoch das Abschirmgehäuse 5 aus mehreren lösbar miteinander verbundenen Teilen 6, 7, 8 besteht, die mindestens so weit geöffnet werden können, daß die Bauelemente und Bauteile der Funktionsgruppe frei zugänglich sind, könnte der Fall eintreten, daß ungeschulte Kräfte an einer solchen Funktionsgruppe arbeiten. Um das zu verhindern oder zumindest erkennbar zu machen, sind die lösbar miteinander verbundenen Teile 6, 7, 8 zusätzlich durch mindestens ein Verschlußelement 11 festgelegt, hierzu weisen die abnehmbaren Deckel 7, 8 je eine Lasche 12 auf, die rechtwinklig zum Gehäuserahmen 6 umgebogen und mit diesem durch ein beide Verbindungsteile durchdringendes Verschlußelement 11 verbunden ist. Ein freier Zugriff zu den Bauelementen und Bauteilen der Funktionsgruppe wird demnach erst dann ermöglicht, wenn das Verschlußelement 11 gelöst wird. Dabei soll das Verschlußelement eine nichtreversible Veränderung erfahren, um den Eingriff in die Funktionsgruppe zu erkennen.

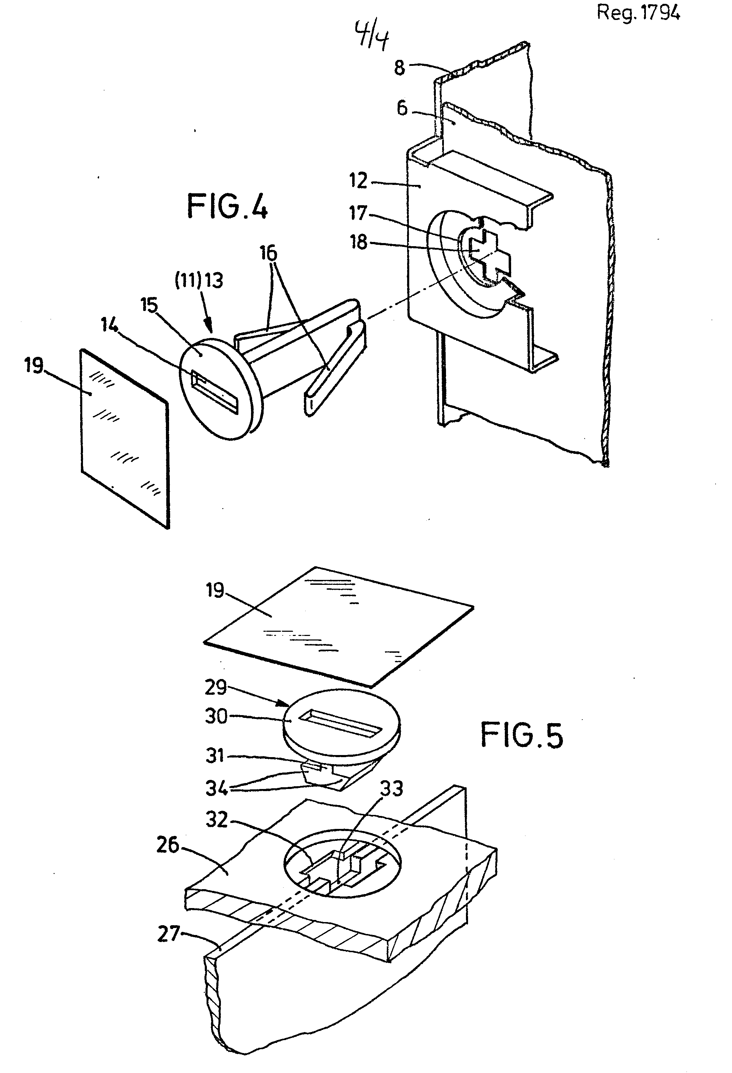

Bei dem in Fig. 4 dargestellten Ausführungsbeispiel eines Verschlußelementes 13 besteht dieses aus einem Kunststoffteil, das einen mit einem Schlitz 14 versehenen Flachkopf 15 und einen daran anschließenden federnden Teil 16 aufweist. Ein solches Verschlußelement wird in Ausnehmungen 17, 18 der Gehäuseteile 12 bzw. 6 eingesetzt. Durch entsprechende Gestaltung der Ausnehmungen 17, 18 ist es möglich, daß beim Drehen des Verschlußelementes 13, z. B. mittels eines Schraubenziehers, eine Schneid- oder Scherwirkung erzeugt wird, durch die der Flachkopf 15 des Verschlußelementes abgetrennt wird. Zu diesem Zweck wird die dem Flachkopf abgewandte Ausnehmung 18 im Gehäuserahmen 6 in Form eines scharfkantigen Kreuzschlitzes ausgebildet, während die andere Ausnehmung 17 im Gehäuseteil 12 eine kreisförmige Bohrung ist.

Zur weiteren Sicherung der Funktionsgruppe gegen unbefugten Eingriff kann eine Versiegelung des Verschlußelements 11, 13 angewendet werden. Bei dem aus Fig. 4 ersichtlichen Verschlußelement 13 ist es zweckmäßig, hierzu einen spezifisch gekennzeichneten Film 19 zu verwenden, der den Flachkopf 15 des Verschlußelements und einen benachbarten Bereich überdeckt. Bei dem Versuch, das Verschlußelement 11, 13 zu lösen, wird dann in jedem Fall die Versiegelung deutlich sichtbar verändert oder zerstört.

Die Ausführungsform einer Funktionsgruppe nach Fig. 2 eignet sich insbesondere für den Tuner-, Abstimm- und ZF-Baustein. Bei diesen Bausteinen ist es bekanntlich besonders wichtig, die einzelnen Baugruppen durch ein möglichst geschlossenes Abschirmgehäuse 5 gegen Störstrahlung sowohl von außen als auch von innen abzuschirmen. Andererseits ist dafür Sorge zu tragen, daß wärmeempfindliche Teile vor der durch die wärmeerzeugenden Teile abgegebenen Wärme geschützt werden. Hierfür werden in an sich bekannter Weise in den Gehäusewandungen Schlitze oder Löcher 20, 21 eingefügt. Diese Öffnungen werden zweckmäßig so angeordnet, daß die Außenluft durch untenliegende Löcher 20 eintritt, sich in dem Gerät erwärmt, und aufsteigt und durch an der Oberseite des Gehäuses angeordnete Öffnungen 21 wieder austritt. Eine weitere Verbesserung bei diesem Aufbau ist möglich, wenn die Abführung der schädlichen Wärme durch zusätzlich im Gehäuse untergebrachte Kühlbleche 22 unterstützt werden kann, die mit dem Abschirmgehäuse 5 wärmeleitend verbunden sind.

Auch die Aufteilung des Abschirmgehäuses 5 in mehrere HF-dichte Kammern kann Vorteile bringen. Zu diesem Zweck wird das metallische Abschirmgehäuse 5 im Innern mit Trennwänden zum Abteilen der einzelnen Schaltungsbaugruppen untereinander versehen.

Ferner können am Abschirmgehäuse 5 an der der Geräterückwand zugewandten Seite eine Antennenanschlußbuchse 23 oder eine andere Buchse, wie z. B. die Videobuchse, für den Anschluß eines Zusatzgerätes mechanisch befestigt werden. Weiter ist es möglich, das Abschirmgehäuse 5 mit Durchbrüchen 24 zu versehen, durch die hindurch Abgleichvorgänge, z. B. nach.einer Reparatur, vorgenommen werden können, oder durch die Meßpunkte zum Anschließen von Prüfgeräten geführt sind bzw. zugänglich werden. Auch diese Meß- und Abgleichanschlußstellen werden zweckmäßigerweise an der der Geräterückwand zugewandten Seite des Abschirmgehäuses 5 angebracht.

Auf der der Geräterückwand abgewandten Seite ist das Abschirmgehäuse 5 mit einem Steckverbindungsteil 25 zum Einstecken in eine den Funktionsgruppen 2 gemeinsame elektrische Leiterplatte 3 versehen. Wie bereits erwähnt, ist diese Leiterplatte in einem um eine Achse schwenkbaren Chassisrahmen 1 angeordnet, die senkrecht zur Bildröhrenachse und in horizontaler Richtung verläuft.

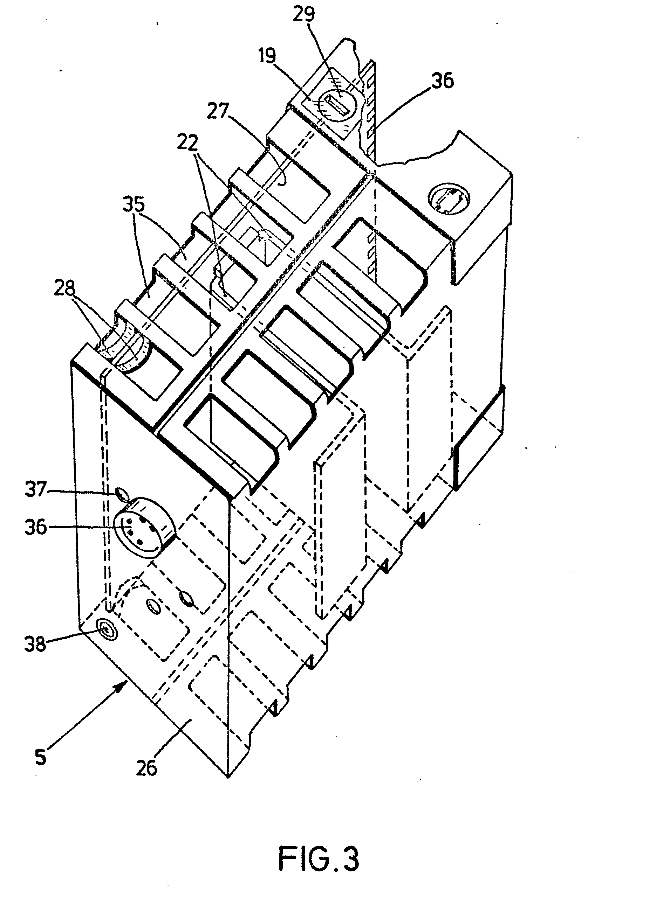

Bei der in Fig. 3 dargestellten Funktionsgruppe besteht das Abschirmgehäuse 5 im wesentlichen aus einem einzigen, einseitig offenen Teil 26. Bei dieser Ausführungsform kann das Gehäuse nicht ohne Beschädigung geöffnet werden. Um dem Service-Techniker den ungehinderten Zugriff zu den Bauelementen und Bauteilen der Funktionsgruppe zu verschaffen, ist die betreffende elektrische Leiterplatte 27 im Abschirmgehäuse 26 herausnehmbar gelagert. Zum Sichern der Lage der Leiterplatte 27 trägt

- 10 -

die Innenseite des Abschirmgehäuses 26 Führungs- und Halteteile 28. Es ist besonders vorteilhaft, diese Führungs- und Halteteile 28 in Form von geschlitzten Prägungen auszubilden.

Um zu verhindern, daß eine ungeschulte Kraft an den Bauelementen und Bauteilen einer solchen Funktionsgruppe arbeitet, ist die Leiterplatte 27 auf zwei Seiten durch je ein Verschlußelement 29 im Abschirmgehäuse 26 festgelegt, so daß erst nach dem Lösen des Verschlußelements die Leiterplatte herausgenommen werden kann, Dabei erfährt das Verschlußelement wiederum eine nichtreversible Veränderung, wie bereits im Vorstehenden ausführlich erläutert worden ist.

Ein hierfür geeignetes Verschlußelement 29 ist in Fig. 5 dargestellt. Auch dieses Verschlußelement besteht aus einem Kunststoffteil, das einen mit einem Schlitz versehenen Flachkopf 30 und einen daran anschließenden federnden Teil 31 aufweist. Das Verschlußelement 29 durchdringt mit dem federnden Teil 31 einen angepaßten Durchbruch 32 im Abschirmgehäuse 26 und greift zugleich in eine angepaßte Ausnehmung 33 am Rand der Leiterplatte 27 ein. Da die Federarme 34 des Teils 31 nach dem Einstecken des Verschlußelements 29 hinter dem Rand des Durchbruchs 32 verrasten, wird eine fest mechanische Verbindung zwischen dem Abschirmgehäuse 26 und der Leiterplatte 27 hergestellt. Beim Drehen des Verschlußelements 29 mit Hilfe eines Schraubenziehers oder ähnlichen Werkzeuges wird diese mechanische Verbindung gelöst, indem der Flachkopf 30 durch Schneid- oder Scherwirkung abgetrennt wird. Zu diesem Zweck ist der dem federnden Teil 31 angepaßte Durchbruch 32 im Abschirmgehäuse 26 wiederum scharfkantig ausgebildet. Auch hier ist es möglich, die Funktionsgruppe zusätzlich durch eine Versiegelung des Flachkopfes 30 des Verschlußelements 29 vor unbefugtem Zugriff zu sichern.

Die beschriebene Funktionsgruppe ist z. B. geeignet für den Netzteil-, Steuer-, Vertikal-, Ost/West-, Rücklauf-, Hinlauf-, Farb- und RGB-Baustein. Das Gehäuse 26 besteht wiederum aus dünnem Abschirmblech mit Entlüftungsschlitzen oder -löchern 35 zur Abführung der Verlustwärme. Ferner kann das Abschirmblech mit den Kühlblechen 22 für wärmeempfindliche Bauelemente wärmeleitend verbunden sein. Weiter kann das Gehäuse 26 an seiner der Geräterückwand zugewandten Seite eine oder mehrere Anschlußbuchsen 36 und außerdem Meß- und Abgleichanschlußstellen 37 zum Prüfen der Funktionsfähigkeit der Funktionsgruppe aufweisen. Beispielsweise ist es möglich, den NF-Baustein mit einer Kopfhöreranschlußbuchse auf diese Weise zu versehen.

Außerdem kann das Abschirmgehäuse 26 an seiner der Geräterückwand zugewandten Seite eine Einrichtung 38 zum Anzeigen einer fehlerhaften Funktion der Funktionsgruppe tragen. Eine solche Einrichtung kann darin bestehen, daß eine Leuchtdiode anzeigt, wenn die Funktionsgruppe nicht mehr einwandfrei arbeitet.

# FERNSEHGERÄTECHASSIS

## Patentansprüche

1. In einzelne steckbare Funktionsgruppen aufgeteiltes Fernsehgerätechassis, g e k e n n z e i c h n e t durch folgende Merkmale:

a) Die Funktionsgruppe (2) ist mit einem ihre Bauelemente und Bauteile vor äußerem Zugriff schützenden Gehäuse (5; 6, 7, 8; 26) versehen;

b) das Gehäuse trägt mindestens auf einer Außenseite ein mit einem Werkzeug lösbares Verschlußelement (11, 13, 29);

c) das Verschlußelement ermöglicht nach dem Lösen einen freien Zugriff zu den Bauelementen und Bauteilen der Funktionsgruppe;

- 2 -

d) es erfährt dabei selbst eine nichtreversible Veränderung, um einen unbefugten Eingriff in die Funktionsgruppe zu erkennen.

2. Fernsehgerät nach Anspruch 1, d a d u r c h  g e - k e n n z e i c h n e t , daß das Gehäuse (5) aus mehreren lösbar miteinander verbundenen Teilen (6, 7, 8) besteht, die zusätzlich durch mindestens ein Verschlußelement (11, 13, 14, 15, 16) festgelegt sind und die nach dem Lösen des Verschlußelements mindestens so weit geöffnet werden können, daß die Bauelemente und Bauteile der Funktionsgruppe (2) frei zugänglich sind.

3. Fernsehgerätechassis nach Anspruch 2, d a d u r c h g e k e n n z e i c h n e t , daß das Gehäuse (5) aus einem rechteckigen Rahmen (6) und zwei diesem angepaßten, abnehmbaren, an den Längsseiten rechtwinklig abgebogenen Deckeln (7, 8) besteht, die einseitig am Rahmen gelenkartig eingehängt und mindestens am anderen Ende durch eine lösbare snap- in-Verbindung (9, 10) und zusätzlich durch ein Verschlußelement (11, 13, 14, 15, 16) am Rahmen festgelegt sind.

4. Fernsehgerätechassis nach Anspruch 3, d a d u r c h g e k e n n z e i c h n e t , daß die abnehmbaren Deckel (7, 8) je eine Lasche (12) aufweisen, die rechtwinklig zum Rahmen (6) umgebogen und mit diesem durch ein beide Verbindungsteile durchdringendes Verschlußelement (11, 13, 14, 15, 16) verbunden ist.

0015302

- 3 -

5. Fernsehgerätechassis nach Anspruch 1, d a d u r c h
g e k e n n z e i c h n e t , daß das Gehäuse (5) im wesentlichen aus einem einzigen, an einer Seite offenen Teil
(26) besteht, der auf seiner Innenseite Führungs- und Halteteile (28), insbesondere in Form von geschlitzten Prägungen,
zum Sichern der Lage einer die Bauelemente und Bauteile tragenden elektrischen Leiterplatte (27) aufweist, die zusätzlich durch mindestens ein Verschlußelement (29, 30, 31, 34)
festgelegt ist und nach dem Lösen des Verschlußelements aus
dem Gehäuse herausgezogen werden kann.

6. Fernsehgerätechassis nach einem oder mehreren der Ansprüche 1 bis 5, d a d u r c h g e k e n n z e i c h n e t,
daß das Verschlußelement (11, 13; 29) aus einem Kunststoffteil
besteht, das einen mit einem Schlitz versehenen Flachkopf (15;
30) und einen daran anschließenden federnden Teil (16; 31, 34)
aufweist, der in entsprechende, in den Verbindungsteilen angebrachte Ausnehmungen (17, 18; 32, 33) eingreift, von denen
mindestens eine (18; 32) scharfkantig und derart ausgebildet
ist, daß beim Drehen des Verschlußelements eine Schneid- oder
Scherwirkung eintritt, durch die der Flachkopf des Verschlußelements abgetrennt wird.

7. Fernsehgerätechassis nach Anspruch 6, d a d u r c h
g e k e n n z e i c h n e t , daß die Funktionsgruppe vor
unbefugtem Eingriff zusätzlich durch ein den Flachkopf (15;
30) des Verschlußelements (11, 13; 29) und einen benachbarten

- 4 -

0015302

Bereich überdeckende Versiegelung (19), insbesondere in Form eines spezifisch gekennzeichneten Filmes, gesichert ist.

8. Fernsehgerätechassis nach einem oder mehreren der Ansprüche 1 bis 7, d a d u r c h  g e k e n n z e i c h n e t , daß das Gehäuse (5) im wesentlichen aus dünnem Abschirmblech mit Entlüftungsschlitzen (20, 21; 35) oder -löchern zur Abführung der Verlustwärme besteht.

9. Fernsehgerätechassis nach Anspruch 8, d a d u r c h  g e k e n n z e i c h n e t , daß das Gehäuse (5) in mehrere HF-dichte Kammern aufgeteilt ist.

10. Fernsehgerätechassis nach Anspruch 8 oder 9, d a - d u r c h  g e k e n n z e i c h n e t , daß das Abschirmblech mit den Kühlblechen (22) für wärmeempfindliche Bauelemente wärmeleitend verbunden ist.

11. Fernsehgerätechassis nach einem oder mehreren der Ansprüche 1 bis 10, d a d u r c h  g e k e n n z e i c h - n e t , daß das Gehäuse (5) oder die im Gehäuse enthaltene Leiterplatte (27) an einer Seite mit einem Steckverbindungsteil (25; 36) zum Einstecken in eine den Funktionsgruppen (2) gemeinsame elektrische Leiterplatte (3) versehen ist, die in einem um eine horizontale Achse schwenkbaren Chassisrahmen (1) angeordnet ist.

0015302

12. Fernsehgerätechassis nach einem oder mehreren der Ansprüche 1 bis 11, d a d u r c h  g e k e n n z e i c h - n e t , daß das Gehäuse (5) an seiner der Geräterückwand zugewandten Seite eine Einrichtung (38) zum Anzeigen einer fehlerhaften Funktion der Funktionsgruppe (2) aufweist.

13. Fernsehgerätechassis nach einem oder mehreren der Ansprüche 1 bis 12, d a d u r c h  g e k e n n z e i c h - n e t , daß das Gehäuse (5) an seiner der Geräterückwand zugewandten Seite eine oder mehrere Anschlußbuchsen (23; 36) und/oder Meßanschlußstellen (24; 37) zum Prüfen der Funktionsfähigkeit der Funktionsgruppe (2) aufweist.

Beschreibung:

FIG.1

FIG.2

FIG.3

FIG.4

FIG.5

Europäisches Patentamt

**EUROPÄISCHER RECHERCHENBERICHT**

0015302
Nummer der Anmeldung

EP 79 10 3125

| | EINSCHLÄGIGE DOKUMENTE | | KLASSIFIKATION DER ANMELDUNG (Int.Cl. 3) |
|---|---|---|---|
| Kategorie | Kennzeichnung des Dokuments mit Angabe, soweit erforderlich, der maßgeblichen Teile | betrifft Anspruch | |
| A | US - A - 4 089 044 (MOTOROLA INC.) <br> * Spalte 5, Zeilen 52-67; Ansprüche; Figur 2 * <br><br> -- | 1,2 | H 05 K 5/00 <br> H 04 N 5/64 |
| A | DE - A - 2 703 889 (SIEMENS A.G.) <br> * AnsOrüche; Figuren 1-4 * <br><br> -- | 3,8,11 | |
| A | PRODUCT ENGINEERING, Band 34, Nr. 11, 27. Mai 1963, Seiten 36,37 <br> J. SCHUSTER: "8 Printed circuit guides" <br> * Seite 37, Bild 7 * <br><br> -- | 5 | RECHERCHIERTE SACHGEBIETE (Int. Cl. 3) <br><br> H 05 K 5/00 <br> 5/04 <br> 9/00 <br> H 04 N 5/64 <br> 5/65 |
| A | US - A - 3 816 911 (MOTOROLA INC.) <br> * Figuren 2,3 * <br><br> -- | 9 | |
| A | US - A - 3 631 299 (SQUARE D. COMP.) <br> * Spalte 4, Zeilen 51-70; Figuren 1,5 * <br><br> -- | 11-13 | |
| A | US - A - 3 211 822 (MARTIN MARIETTA CORP.) <br> * Ansprüche; Figuren 1-11 * <br><br> ---- | 10 | KATEGORIE DER GENANNTEN DOKUMENTE <br> X: von besonderer Bedeutung <br> A: technologischer Hintergrund <br> O: nichtschriftliche Offenbarung <br> P: Zwischenliteratur <br> T: der Erfindung zugrunde liegende Theorien oder Grundsätze <br> E: kollidierende Anmeldung <br> D: in der Anmeldung angeführtes Dokument <br> L: aus andern Gründen angeführtes Dokument <br> &: Mitglied der gleichen Patentfamilie, übereinstimmendes Dokument |

Der vorliegende Recherchenbericht wurde für alle Patentansprüche erstellt.

| Recherchenort | Abschlußdatum der Recherche | Prüfer |
|---|---|---|
| Den Haag | 02-06-1980 | VAN REETH |

EPA form 1503.1   06.78